# EUROPEAN PATENT SPECIFICATION

(11) **EP 0 296 066 B1**
(45) Date of publication and mention of the grant of the patent: **12.01.1994**
(21) Application number: 88401506.6
(22) Date of filing: 16.06.1988
(51) Int. Cl.: H01S 3/103, H01S 3/19, G02F 1/015

(54) **An integrated laser device with refractive index modulator**
Integrierte Laservorrichtung mit Brechungsindex-Modulator
Dispositif de laser intégré avec modulateur d'indice de réfraction

(30) Priority: 17.06.1987 JP 149141/87
(43) Date of publication of application: 21.12.1988
(73) Proprietor: FUJITSU LIMITED, Kawasaki-shi, Kanagawa 211 (JP)
(72) Inventor: Yano, Mitsuhiro, Ebina-shi Kanagawa 243-04 (JP)
(74) Representative: Joly, Jean-Jacques

(56) References cited:
- US-A- 3 702 975
- US-A- 4 492 434
- US-A- 4 525 687
- US-A- 4 589 117
- US-A- 4 633 476
- PROCEEDINGS OF SPIE, vol. 564, August 1985, Washington WOOD "High-speed optical modulation and bistability with semiconductor multiple quantum wells" pages 167-172
- IEEE JOURNAL AT QUANTUM ELECTRONICS, vol. QE-23, No. 6, June 1987, pp. 835-838
- ELECTRONICS LETTERS, vol. 23, No. 7, 26th March 1987, pp. 325-327

## Description

### BACKGROUND OF THE INVENTION

This invention relates to an integrated semiconductor laser device monolithically integrated with an MQW (Multi-Quantum-Well) modulator.

In recent years, many light communication systems have been installed using a semiconductor laser as a source of coherent light modulated in a digital or pulse signal, wherein an injection current to the laser is switched from one state to another state by an outside circuitry. Although pulse modulation is at present the most popular technology in light communication systems, other modulations such as FM, PM, FSK, and PSK, are now widely used in other types of electrical communication systems. But such modulations involve difficult problems if applied to light communication systems. In order to transmit a lot of information or to increase the transmission distance without amplification, it is requested to use a modulation method other than pulse modulation, and, to achieve this object, it is an urgent requirement to develop a laser device or an apparatus such that the oscillating frequency or phase (these words depending on the modulation method considered, the terms "light wavelength" will be used hereinafter instead of frequency or phase to simplify the explanation) can be controlled by an electrical modulating signal from an outside circuitry.

The light wavelength of a semiconductor laser is primarily determined by factors such as the band-gap of the semiconductor medium constituting the active layer of the laser, the longitudinal length thereof defining a resonance of oscillation, in case of a DFB (Distributed Feed Back) laser, the pitch of diffraction grating, the effective refractive index of the light resonator in the laser, the operating temperature thereof, etc... However, the length and the material used in a laser cannot be changed once the laser is fabricated and put into operation.

In designing a semiconductor laser device, the semiconductor material of an active layer is first considered. A semiconductor material has its own band gap characterisitic, and the band-gap principally determines the oscillating light wavelength. However, the curve representing the variation of light output versus wavelength in a laser has a peak value at the center wavelength and gradually drops on both sides thereof. Actual oscillation wavelength is further dependent upon factors such as dimensional factors regulating the light resonator, the plasma state of the semiconductor material in the active layer, the injection current, the refractive index, etc... Moreover, the refractive index also varies as a function of the plasma state of the semiconductor. The structure of a laser is designed taking all these factors into consideration.

As described above, the refractive index can be changed by controlling the injection current to the active layer of the laser. It is however difficult to utilize this phenomenon directly to control the oscillation wavelength by modulating the injection current, because the control of the current flowing across the active layer in forward direction raises some problems such as related to a leakage current or a temperature rise of the laser device during operation.

As one solution to the above difficulty, it has been proposed in the prior art to separate the laser into two parts arranged on the same substrate by means of a crossing trench extending normally to a light propagating direction, a first part being utilized for laser oscillation, and the second part being utilized for changing the wavelength by controlling the injection current thereto, thus changing the plasma state of the second part resulting in a change to the composite value of the overall refractive index.

Such a semiconductor laser is disclosed in IEEE Journal of Quantum Electronics, Vol QE-23, No.6, June 1987, pages 835-838. Another electrically wavelength-tunable semiconductor laser is disclosed in Electronics Letters, Vol. 23, No.7, 26th March 1987, pages 325-327.

According to another method for controlling the wavelength, a reflecting mirror or a diffraction grating is disposed outside of the laser, resulting in a change of the wavelength of the composite resonator. However, it is difficult to tune the wavelength electrically.

A further drawback of the above-mentioned prior art methods for controlling the wavelength lies in that a variable range of 5 nm at most is achievable for 1.3 to 1.6 µm wavelength range, and the light output is unstable.

### SUMMARY OF THE INVENTION

Therefore, it is a general object of the invention to provide a semiconductor laser device having a broad tunable range in oscillating light wavelength.

It is a more specific object of the invention to provide a semiconductor laser device having means for controlling the light wavelength, said means comprising monolithically integrated quantum well structure and light oscillating portion on a same substrate.

It is another object of the invention to provide a semiconductor laser device having means capable of controlling the oscillation wavelength electrically and consuming almost no electric power, resulting in no additional heat dissipation within the device.

It is still another object of the invention to provide a semiconductor laser device which can be fabricated using substantially the same process technology as used for fabricating conventional laser devices.

To achieve the above and other objects, the present invention provides a semiconductor laser device comprising : a semiconductor substrate of a first conductivity type; a diffraction grating (2) formed in the upper surface of the substrate; a first clad layer of a first conductive type formed over said semiconductor substrate; an active layer formed on said first clad layer; a second clad layer of a second conductivity type formed on the upper surface of said active layer; a multi-quantum well layer formed on said second clad layer, said multi-quantum-well layer being optically coupled with said active layer; a contact layer of the first conductivity type formed on the upper surface of said multi-quantum-well layer; means for supplying a forward voltage between said first clad layer and said second clad layer; and means for supplying a reverse voltage between said second clad layer and said contact layer.

By varying the reverse voltage, i.e. by controlling the electric field within the multi-quantum-well layer, the output light wavelength of the laser device can be modulated.

### BRIEF DESCRIPTION OF THE DRAWINGS

Fig. 1 shows a schematic cross section of a conventional DFB laser of the prior art;
Fig. 2 illustrates a relation between the effective refractive index of the light transmission guide of Fig. 1 and the refractive index of each constituting layer;
Fig. 3 shows a schematic cross section illustrating a single quantum well;
Fig. 4 illustrates a curve showing the relation between the width of the single quantum well and the maximum percent change of the refractive index thereof;
Fig. 5 schematically shows the change in refractive index when the well layer and barrier layer are subjected to a reverse voltage;
Fig. 6(a) shows the light intensity distribution in the light transmission guide in order to explain the position where the MQW layer is to be formed, and Fig. 6(b) shows the bottom level of conduction band Ec corresponding to the position of Fig. 6(a);
Fig. 7 shows a cross section of a semiconductor laser device according to one embodiment of the present invention;
Fig. 8 shows a cross section taken along line A-A of Fig. 7; and
Fig. 9 illustrates a curve showing test results on the relation between the applied bias voltage and the percent refractive index change and the relation between the applied bias voltage and a controllable wavelength range.

### DETAILED DESCRIPTION OF PREFERRED EMBODIMENTS

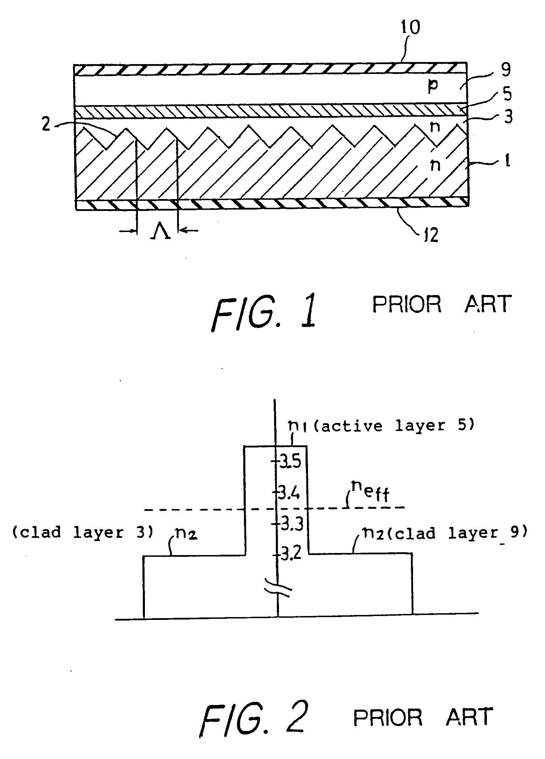

Before entering the detailed description of an embodiment of the invention, the structure of a conventional DFB laser and the factors influencing the oscillation frequency will be explained with reference to Fig. 1.

Fig. 1 is a schematic cross-sectional view of a DFB laser used for a 1.3 to 1.6 µm wavelength range. An n-type InP substrate 1 is provided having an n-type InP clad layer 3 laminated thereon. Between clad layer 3 and substrate 1, a diffraction grating 2 is formed. An InGaAsP active layer 5 and a p-type InP clad layer 9 are formed on clad layer 3. Electrodes 10 and 12 are formed on the top and bottom surfaces, respectively, for connection to the positive and negative terminals of a power supply source (not shown).

The semiconductor material InGaAsP used for the active layer 5 is a quaternary alloy semiconductor material, and the composition ratio of each constituent element is determined by an energy band-gap of the quarternary semiconductor or the light wavelength which this material can generate when excited. The light resonator, which forms the light transmission guide, is composed of active layer 5, n-type clad layer 3, diffraction grating 2 and a thin layer of p-type clad layer 9 contacting active layer 5. The pitch Λ of diffraction grating and the effective refractive index of the above light transmission guide determine the resonance frequency of the light resonator. When the energy band-gap curve of the active layer has a wavelength corresponding to the above light resonator, light oscillation will build up.

In order to confine the light beam within a thin layer of the light transmission guide, the refractive index n₁ of active layer 5 should be larger than the refractive index n₂ of both contacting clad layers 3 and 9. In the present case, index n₁ of InGaAsP has a value of about 3.55 and index n₂ of InP has a value of about 3.20; then, the effective refractive index n_{eff} has a value of between 3.3 and 3.4 depending on the thickness of these layers, as illustrated in Fig. 2. The thickness of the active layer is selected to be within the range of 0.1 to 0.2 µm, and the contacting clad layers, which have a thickness in the range of less than about 0.5 µm, give an effect on the effective refractive index n_{eff} or the output light wavelength.

The refractive index of each layer forming the light transmission guide slightly changes depending on factors such as the temperature thereof, the injection current, bulk semiconductor Stark effect due to the electric field applied thereto, etc... These cause usually an unwanted drift or change in the output light wavelength.

For a long time, Stark effect has been known as a phenomenon that, when the material is subjected to an electric field, the value of the frequency of electro-magnetic wave or optical absorption shifts from its value in the absence of electric field. Recently, the Stark effect in quantum well structure, which influences the shift of optical absorption and accompanying change of refractive index, has been studied and reported. The following references disclose some of the characteristics of a quantum well structure under the influence of electric field:
"Band-Edge Electroabsorption in Quantum Well Structure: The Quantum-Confined Stark Effect" by D.A.B. Miller, et al; Physical Review Letters, Vol. 53, No. 22, Nov. 1984;
"Multiple quantum well waveguide modulators" by T.H. Wood, et al; International Conference on Optical Fibre Communications, Feb. 1986;
High-speed electroabsorption modulator with strip-loaded InGaAsP planar waveguide" by Y. Noda, et al; Internationl Conference on Optical Fibre Communications, Feb. 1986; and
"Highly efficient waveguide phase modulator for integrated optoelectronics" by A. Alping, et al; Appl. Phys. Lett. 48(19), 12 May, 1986.

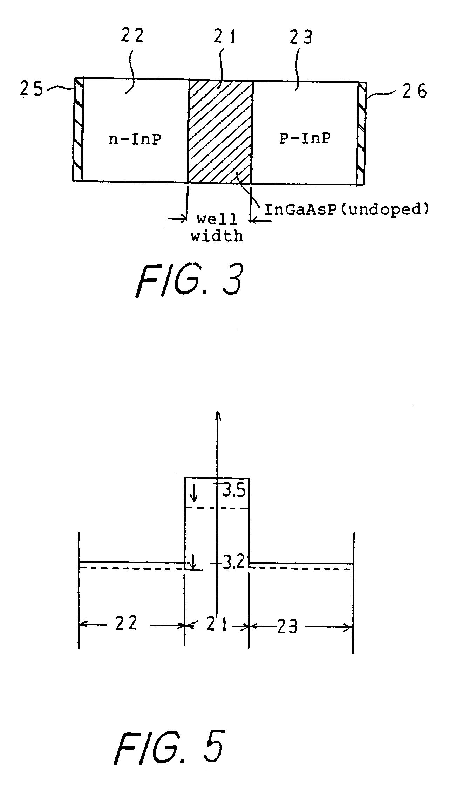

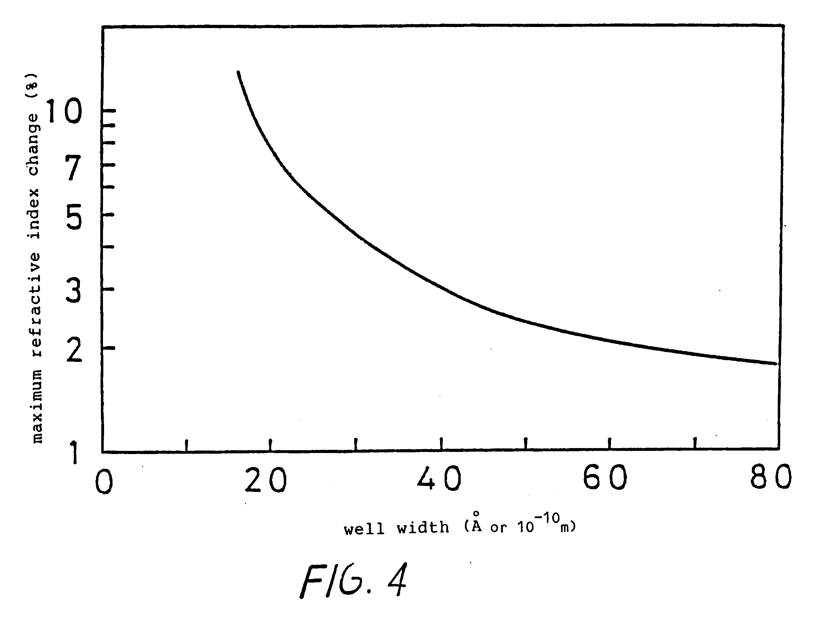

The present invention positively utilizes the Stark effect in a quantum well structure for changing the oscillation wavelength of a laser. Before going into the MQW structure, a single quantum well, as shown in Fig. 3, will be considered at first. An undoped InGaAsP well layer 21, having an energy band gap equivalent to 1.5 µm, is provided and sandwiched between two barrier layers of n-type InP 22 and p-type InP 23. The width of the well layer 21 is selected sufficiently thin, less than 10 nm. Contact electrodes 25, 26 are formed, a bias voltage Vb is applied therebetween and the well layer is subjected to a light of 1.55 µm wavelength. In Fig. 3, electrodes 25 and 26 are connected to the positive and negative terminals, respectively, of a power source (not shown). The reverse voltage Vb is selected such that it provides a maximum change in the refractive index of InGaAsP well layer 21. but without causing a breakdown of the well layer. A calculated curve illustrating well width versus maximum percent of refractive index change is shown in Fig. 4. The maximum percent of refractive index change rapidly increases (in this case, the refractive index decreases) with a decrease of the well width and exceeds 10% at the lower end portion of the width range.

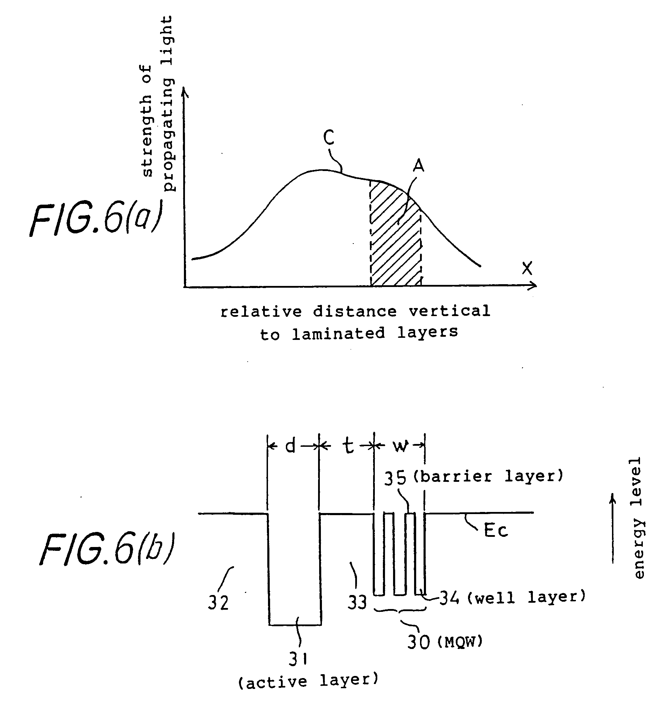

The refractive index curve is shown schematically in Fig. 5, the solid line showing the data without application of bias voltage Vb and the dashed line showing the data in the presence of an electric field due to the application of the bias voltage. In Fig. 5, the refractive indexes of both barrier layers 22, 23 show a slight decrease, which is caused by the Franz-Keldysh effect, details of which are not referred to here. On the other hand, the refractive index of well layer 21 shows a larger decrease according to the curve of Fig. 4.

When a plurality of quantum well layers are laminated to form a MQW layer, the effective refractive index n_{mqw} can be calculated by a method according to which each of the total width of well layers and barrier layers is multiplied with the respective refractive index and the results are averaged by dividing by the total width of the MQW layer. The controllable range of the effective refractive index n_{mqw} of the MQW layer can thus be obtained for a given bias voltage Vb across the MQW layer.

Furthermore, the MQW layer should be formed within a sufficiently neighbouring region so that the MQW layer influences the resonance wavelength of the light resonator by disposing the MQW layer within a distance of about 0.5 µm from the active layer. In order to obtain an effective variable range of light wavelength of the laser device, the effective refractive index nᵣₑₛ of the overall synthetic light resonator is to be calculated, the refractive indexes of all the layers constituting the light resonator being taken into consideration.

This situation is schematically illustrated in Fig. 6. In Fig. 6(a), the abscissa represents an arbitrary relative distance x vertical to the laminated layers of the optical resonator, and the ordinate represents an electric field strength of the propagating light within the light resonator. In other words, the curve of Fig. 6(a) shows the equivalent data of light strength, and also the relative data of the refractive index at each position when the laser is put into operation. Fig. 6(b) shows the bottom of the conduction band Ec in the energy level diagram for each layer. The active layer 31 made of a material such as InGaAsP is sandwiched between two clad layers 32, 33 of InP. The MQW layer 30 consists of well layers 34 of InGaAsP each having a thickness preferably less than 4 nm, and barrier layers 35 of InP. The barrier layers 35 having a higher energy level of Ec at non-bias state and the well layers having a lower level are alternately laminated to form the MQW layer 30. The positional relation between Figs. 6(a) and 6(b) shows that MQW layer 30 is formed under the umbrella of curve C of Fig. 6(a). This condition is an important point in designing a variable wavelength laser using the MQW layer. The change of effective refractive index n_{mqw} of MQW by bias voltage brings about a change of the hatched area A under curve C of Fig. 6(a), resulting in changes of effective refractive index nᵣₑₛ and light frequency.

Therefore, the width w of MQW is selected properly such that the area A occupies a proper portion of the area under the unmbrella of curve C. If the width w is much smaller than the thickness of active layer d(w«d), the area A takes a small portion of the total area under curve C and then an effective variable range of wavelength is not likely to be expected. On the contrary, if the width w is much larger than d (w»d), the change of effective refractive index n_{mqw} contributes to a wider change of the total effective refractive index [of] nᵣₑₛ or the light wavelength. However, it incurs an increase of threshold current of the laser. Therefore it is preferable to select for width w a value close to that of the thickness d of the active layer.

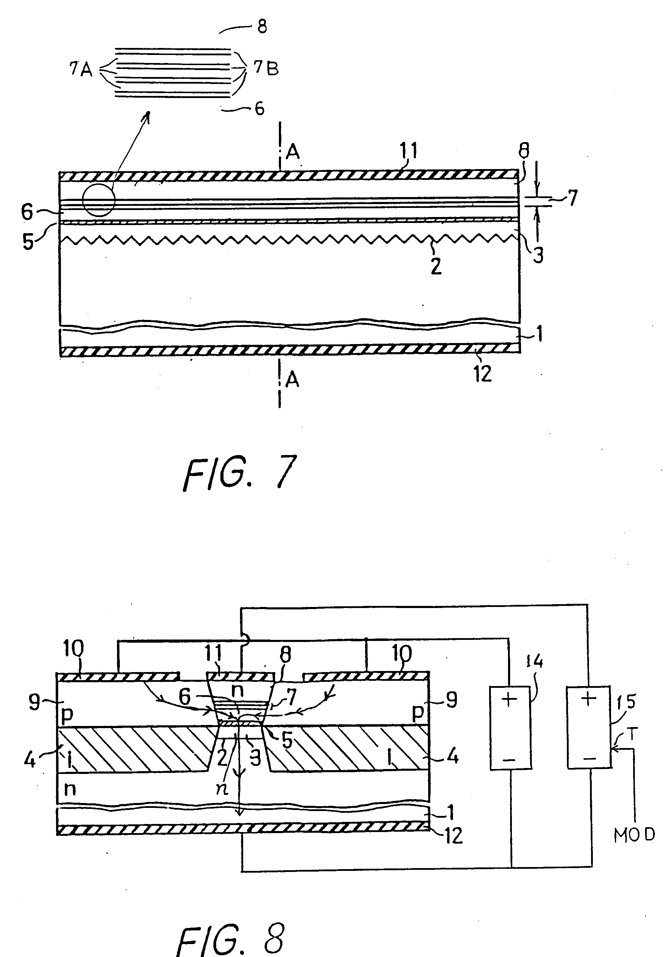

An embodiment of an actual structure of a wavelength controllable laser device according to the present invention is shown in Fig. 7, in cross section along the direction of the light beam. A cross-sectional view taken along line A-A of Fig. 7 is shown in Fig. 8, with power sources connected thereto.

To fabricate a buried heterostructure such as shown in Figs. 7 and 8, several methods may be carried out. As for the epitaxial growth, methods such as liquid phase epitaxial growth and MBE (Molecular Beam Epitaxy) are generally used. However, the invention utilizes the MQW structure which can be fabricated only by the MBE method.

For manufacturing a laser device of wavelength 1.55 µm, an n-type InP substrate 1 is used, and then a diffraction grating 2 is formed on the surface of the n-type InP substrate 1, using a known technology such as two light beam interference exposure method. The pitch Λ of the grating is selected to satisfy the condition ${\text{Λ = m x (λ/2n}}_{\text{res}} \text{)}$ , where λ is the output light wavelength, m is an integer, and nᵣₑₛ is the equivalent refractive index of the light resonator.

Then, an n-type InP clad layer 3 having an impurity density of 5 x 10¹⁷/cm³ and a thickness of 0.12 to 0.22 µm, an undoped InGaAsP active layer 5 having a thickness of 0.1 µm, and a p-type InP clad layer 6 having an impurity density of 1∼2 x 10¹⁸/cm³ are successively formed one by one. Thereafter, an MQW layer 7 is grown thereon by an MBE method, the MQW layer being composed of 12 InGaAsP well layers 7B having a thickness equal to 2 nm and 11 InP barrier layers 7A having a thickness of 2 nm, and an n-type InP layer 8 having an impurity density of 5 x 10¹⁷/cm³ and a thickness of 1 to 1.5 µm is grown thereon.

To fabricate the strip-shaped laminated layers buried with high resistive layer 4 and p-type InP layer 9 on both sides thereof, the entire surface of the above substrate with laminated layers is subjected to a deposition process of silicon dioxide. Then, the silicon dioxide layer is partly removed, except the strip-shaped area, by a photolithography technique. Laminated layers for both sides of strip-shaped area are then etched away using a wet etching process until the specified depth can be obtained, and then high resistive layer 4 of intrinsic InP and subsequently p-type InP layer 9, having an impurity density of 1 x 10¹⁸/cm³ and a thickness of 1 to 1.5 µm, are grown.

Two electrodes 10, 11 and one electrode 12 are formed on the upper and bottom surfaces using TiPtAu and AuGeNi material, respectively. The electrode 10 is connected to a power source 14 for laser oscillation, the electrode 11 is connected to power source 15 for supplying a reverse voltage, and the electrode 12 is used for the negative common connection.

When the completed laser device is shown in Figs. 7 and 8 is put into operation, the driving current for laser oscillation by a forward bias voltage between the two clad layers 3 and 6, flows along the path shown by arrows, namely electrode 10, p-type InP layer 9, p-type InP clad layer 6, InGaAsP active layer 5, n-type InP clad layer 3, n-type InP substrate 1, and electrode 12. High resistive layer 4 prevents the current flowing through this layer 4 and forces the current to flow through the InGaAsP active layer 5. Therefore, the surface level of the high resistive layer 4 is required to be not lower than that of the upper surface of n-type InP clad layer 3 in order to prevent direct current flow from p-type InP layer 9 to n-type InP clad layer 3.

On the other hand, the buried strip-shaped layers of n-type InP layer 8, MQW layer 7, and p-type InP clad layer 6 are subjected to a reverse bias voltage Vb supplied by power source 15, whereby n-type contact layer 8 is set to a positive voltage with regard to p-type clad layer 6. Therefore, no current flows therethrough. When the voltage Vb is varied, the change of refractive index n_{mqw} of MQW layer 7 causes the effective refractive index nᵣₑₛ of overall optical resonator also to change, and this results in making it possible to modulate the output light wavelength from the laser device.

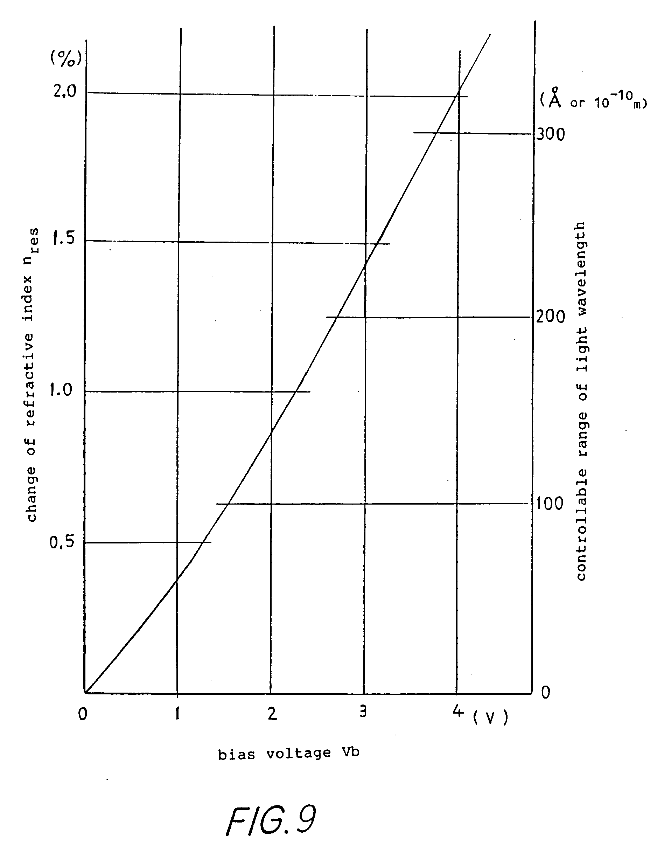

Test results obtained with the 1.55 µm laser device are illustrated by Fig. 9. The abscissa represents the bias voltage Vb. In actual operation, the oscillating portion of the device is subjected to the forward voltage supplied by power source 14. Therefore, p-type clad layer 6 is driven to a positive voltage with regard to the common negative terminal voltage of power source 14. The bias voltage Vb in Fig. 9 means the voltage, of which a substantial portion thereof is applied across the MQW layer 7, and which is almost equal to the difference between the voltages applied to electrode 11 and electrode 10. The ordinate represents the change of refractive index nᵣₑₛ in percent (in this case, the change is negative) of the light resonator on the left-hand side of Fig. 9 and the controllable range of light wavelengths on the right-hand side of Fig. 9. The application of a bias voltage clearly results in an increase of the controllable range of light wavelength compared with the state without bias voltage. The maximum change in light wavelength reaches approximately 35nm. This value is much larger than those obtained in the prior art such as 5 nm at most. When the modulating signal is superposed on bias voltage Vb from terminal T connected to power source 15, the output light wavelength can be modulated according to the modulation signal.

Although only one embodiment of the invention in the form of a 1.55 µm laser device has been disclosed and described, it is apparent that the present invention can be extended to other structures and wavelengths without departing from the essential characteristics thereof.

## Claims

1. An integrated semiconductor laser device comprising:
a semiconductor substrate (1) of a first conductivity type; a diffraction grating (2) formed in the upper surface of the substrate;
a first clad layer (3) of a first conductive type formed over said semiconductor substrate;
an active layer (5) formed on said first clad layer;
a second clad layer (6) of a second conductivity type formed on the upper surface of said active layer;
a multi-quantum-well layer (7) formed on said second clad layer, said multi-quantum-well layer being optically coupled with said active layer;
a contact layer (8) of the first conductivity type formed on the upper surface of said multi-quantum-well layer;
means (14) for supplying a forward voltage between said first clad layer and said second clad layer; and
means (15) for supplying a reverse voltage (Vb) between said second clad layer (6) and said contact layer (8).

2. A laser device according to claim 1, characterized in that the first clad layer (3), the active layer (5), the second clad layer (6), the multi-quantum-well layer (7) and the contact layer (8) are formed in a strip-shaped pattern, and said laser device further comprises a high resistive layer (4) on the substrate and a conductive layer (9) of the second conductivity type formed thereon, both layers being formed on both sides of said strip-shaped patterns and burying these patterns.

3. A laser device according to claim 2, characterized in that said high resistive layer (4) is thick enough to avoid said conductive layer (9) to contact directly with said first clad layer (3).

4. A laser device according to any one of claims 1 to 3, characterized in that said multi-quantum-well layer is formed in a close vicinity where the propagating light has enough light intensity.

5. A laser device according to any one of claims 1 to 4, characterized in that the thickness of each well layer of said multi-quantum-well layer is selected to be less than 4 nm.

6. A laser device according to any one of claims 1 to 5, characterized in that the total thickness of said multi-quantum-well layer (7) is selected to be substantially the same thickness of said active layer (5).

7. A laser device according to any one of claims 2 and 3, characterized in that it further comprises a first electrode (10) on said conductive layer (9) and a second electrode (11) on said contact layer (8), the pattern of said electrodes being separated from each other, said first electrode (10) being connected to the forward voltage supply means (14) and said second electrode (11) being connected to the reverse voltage supply means (15).

## Patentansprüche

1. Integriertes Halbleiterlaserbauelement, umfassend:
Ein Hauptleitersubstrat (1) eines ersten Leitungstyps;
ein auf der Oberseite des Substrats gebildetes Beugungsgitter (2);
eine erste Überzugsschicht (3) eines ersten Leitungstyps, die über dem Halbleitersubstrat gebildet ist;
eine auf der ersten Überzugsschicht gebildete aktive Schicht (5);
eine zweite Überzugsschicht (6) eines zweiten Leitungstyps, die auf der Oberseite der aktiven Schicht gebildet ist;
eine auf der zweiten Überzugsschicht gebildete Mehr-Quantenloch-Schicht (7), welche mit der aktiven Schicht optisch gekoppelt ist;
eine Kontaktschicht (8) des ersten Leitungstyps, welche auf der Oberseite der Mehr-Quantenloch-Schicht gebildet ist;
eine Einrichtung (14) zum Anlegen einer Durchlaßspannung zwischen die erste Überzugsschicht und die zweite Überzugsschicht; und
eine Einrichtung (15) zum Anlegen einer Sperrspannung (Vb) zwischen die zweite Überzugsschicht (6) und die Kontaktschicht (8).

2. Laserbauelement nach Anspruch 1,
**dadurch gekennzeichnet,**
daß die erste Überzugschicht (3), die aktive Schicht (5), die zweite Überzugschicht (6), die Mehr-Quantenloch-Schicht (7) und die Kontaktschicht (8) in einem streifenförmigen Muster ausgebildet sind, wobei das Laserbauelement außerdem eine Schicht (4) hohen Widerstands auf dem Substrat und eine darauf ausgebildete leitende Schicht (9) des zweiten Leitungstyps aufweist, wobei beide Schichten auf beiden Seiten der streifenförmigen Muster ausgebildet sind und diese Muster vergraben.

3. Laserbauelement nach Anspruch 2,
**dadurch gekennzeichnet,**
daß die Schicht (4) hohen Widerstands dick genug ist, um zu vermeiden, daß die leitende Schicht (9) direkt mit der ersten Überzugschicht (3) in Berührung steht.

4. Laserbauelement nach jedem der Ansprüche 1 bis 3,
**dadurch gekennzeichnet,**
daß die Mehr-Quantenloch-Schicht in enger Nachbarschaft zu der Stelle ausgebildet ist, an der das sich ausbreitende Licht genügende Lichtintensität aufweist.

5. Laserbauelement nach jedem der Ansprüche 1 bis 4,
**dadurch gekennzeichnet,**
daß die Dicke jeder Lochschicht der Mehr-Quantenloch-Schicht so gewählt ist, daß sie weniger als 4 nm beträgt.

6. Laserbauelement nach jedem der Ansprüche 1 bis 5,
**dadurch gekennzeichnet,**
daß die Dicke der Mehr-Quanten-Loch-Schicht (7) so ausgewählt ist, daß sie im wesentlichen die gleiche Dicke hat wie die aktive Schicht (5).

7. Laserbauelement nach jedem der Ansprüche 2 und 3,
**dadurch gekennzeichnet**,
daß es außerdem eine erste Elektrode (10) auf der leitenden Schicht (3) und eine zweite Elektrode (11) auf der Kontaktschicht (8) aufweist, wobei die Muster der Elektroden voneinander getrennt sind, die erste Elektrode (10) an die Durchlaßspannungs-Anlegeeinrichtung (14) und die zweite Elektrode (11) an die Sperrspannungs-Anlegeeinrichtung (15) angeschlossen ist.

## Revendications

1. Dispositif laser à semiconducteur intégré, comprenant :
un substrat semiconducteur (1) d'un premier type de conductivité;
un réseau de diffraction (2) formé sur la surface supérieure du substrat ;
une première couche de revêtement (3), d'un premier type de conductivité, formée sur ledit substrat semiconducteur ;
une couche active (5) formée sur ladite première couche de revêtement ;
une deuxième couche de revêtement (6), d'un deuxième type de conductivité, formée sur la surface supérieure de ladite couche active ;
une couche (7) à plusieurs puits quantiques, formée sur ladite deuxième couche de revêtement, ladite couche à plusieurs puits quantiques étant optiquement couplée avec ladite couche active ;
une couche de contact (8), du premier type de conductivité, formée sur la surface supérieure de ladite couche à plusieurs puits quantiques ;
un moyen (14) servant à appliquer une tension de sens passant entre ladite première couche de revêtement et ladite deuxième couche de revêtement ; et
un moyen (15) servant à appliquer une tension inverse (Vb) entre ladite deuxième couche de revêtement (6) et ladite couche de contact (8).

2. Dispositif laser selon la revendication 1, caractérisé en ce que la première couche de revêtement (3), la couche active (5), la deuxième couche de revêtement (6), la couche à plusieurs puits quantiques (7) et la couche de contact (8) sont formées en une configuration en forme de bande, et ledit dispositif laser comprend en outre une couche hautement résistive (4) sur le substrat et une couche conductrice (9), du deuxième type de conductivité, formée sur celle-ci, les deux couches étant formées des deux côtés desdites configurations en forme de bande et enterrant ces configurations.

3. Dispositif laser selon la revendication 2, caractérisé en ce que ladite couche hautement résistive (4) est suffisamment épaisse pour éviter que ladite couche conductrice (9) soit directement en contact avec ladite première couche de revêtement (3).

4. Dispositif laser selon l'une quelconque des revendications 1 à 3, caractérisé en ce que ladite couche à plusieurs puits quantiques est formée dans un proche voisinage où la lumière se propageant possède une intensité lumineuse suffisante.

5. Dispositif laser selon l'une quelconque des revendications 1 à 4, caractérisé en ce que l'épaisseur de chaque couche de puits de ladite couche à plusieurs puits quantiques est choisie de façon à être inférieure à 4 nm.

6. Dispositif laser selon l'une quelconque des revendications 1 à 5, caractérisé en ce que l'épaisseur totale de ladite couche à plusieurs puits quantiques (7) est choisie de façon à être sensiblement la même que l'épaisseur de ladite couche active (5).

7. Dispositif laser selon l'une quelconque des revendications 2 et 3, caractérisé en ce qu'il comprend en outre une première électrode (10) se trouvant sur ladite couche conductrice (9) et une deuxième électrode (11) se trouvant sur ladite couche de contact (8), les motifs desdites électrodes étant séparés l'un de l'autre, ladite première électrode (10) étant connectée au moyen (14) appliquant l'alimentation de sens direct, et ladite deuxième électrode (11) étant connectée au moyen (15) appliquant la tension de sens inverse.
